# FASCICULE DE BREVET EUROPEEN

(11) **EP 3 358 631 B1**
(45) Date de publication et mention de la délivrance du brevet: **31.07.2019**
(21) Numéro de dépôt: 18154922.1
(22) Date de dépôt: 02.02.2018
(51) Int. Cl.: H01L 31/18, H01L 21/26, H01L 21/265, H01L 21/266, H01L 21/3065

(54) **FORMATION DE RELIEFS À LA SURFACE D'UN SUBSTRAT**
BILDUNG VON RELIEFS AUF DER OBERFLÄCHE EINES SUBSTRATS
FORMATION OF RAISED PATTERNS ON THE SURFACE OF A SUBSTRATE

(30) Priorité: 02.02.2017 FR 1750864
(43) Date de publication de la demande: 08.08.2018
(73) Titulaire: Commissariat à l'Energie Atomique et aux Energies Alternatives, 75015 Paris (FR)
(72) Inventeur: NOURI, Lamia, 38100 Grenoble (FR); LANDIS, Stefan, 38210 Tullins (FR); POSSEME, Nicolas, 38360 Sassenage (FR)
(74) Mandataire: Hautier, Nicolas

(56) Documents cités:
- WO-A1-2016/145337
- US-A1- 2014 206 195
- US-A1- 2015 380 599

## Description

### DOMAINE DE L'INVENTION

La présente invention concerne un procédé de structuration de la surface d'un substrat et plus généralement un procédé de réalisation de motifs à la surface d'un substrat.

L'invention trouve pour application avantageuse mais non limitative la fabrication de dispositifs microélectroniques. Par dispositif microélectronique, on entend tout type de dispositif réalisé avec les moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...).

Un domaine d'application particulièrement avantageux mais non limitatif concerne la réalisation de cellules photovoltaïques.

### ARRIERE-PLAN TECHNOLOGIQUE

La possibilité d'obtenir des tranches ou plaques (« wafers ») et des substrats, à surface structurée (« patterned substrate ») c'est-à-dire dont la surface est au moins en partie couverte de motifs en relief, peut s'avérer très avantageuse. C'est en particulier le cas pour les cellules photovoltaïques et la plupart des dispositifs de type optiques ou optoélectroniques, notamment les diodes électroluminescentes (DEL) dont l'efficacité de conversion d'un courant électrique en lumière est très dépendante de l'état de surface du substrat à partir duquel on les fabrique.

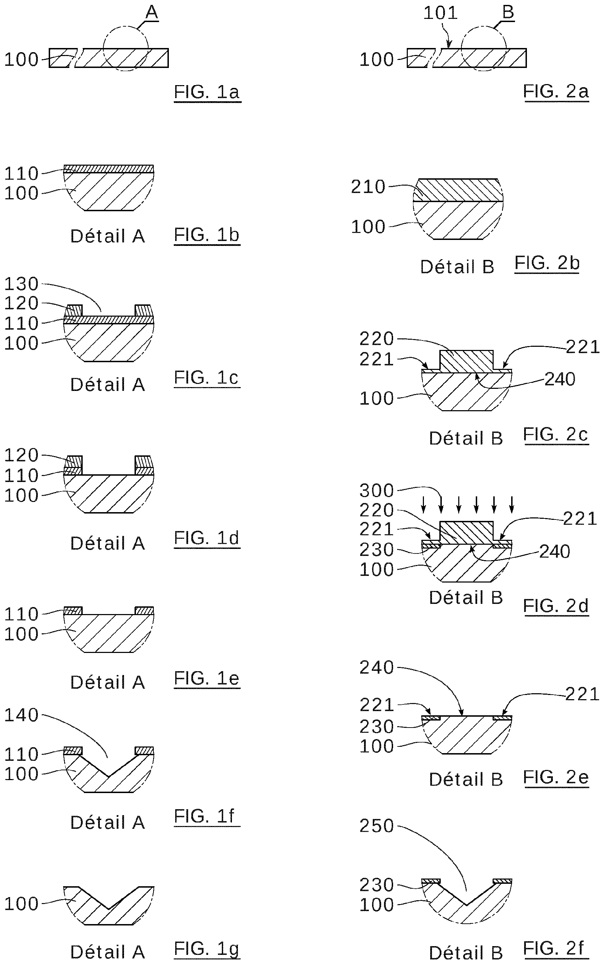

Les procédés existants pour structurer des substrats comprennent de nombreuses étapes dont une revue synthétique est reproduite aux figures 1a à 1f.

La figure 1a illustre un substrat 100 sur lequel les reliefs sont à réaliser. Sur cette base, la technique conventionnelle actuelle propose la création d'une couche de masque dur 110 généralement faite de nitrure de silicium d'oxyde ou de silicium. Cette couche 110 est déposée sur une face du substrat 100, comme illustré en figure 1b. Un ou plusieurs motifs 130 sont ensuite définis dans la couche 110 de sorte à exposer de manière sélective certaines parties de la face du substrat 100 tout en protégeant d'autres parties par le masque dur.

Pour définir ces motifs 130, comme illustré en figure 1c, on prévoit de manière classique le dépôt d'une couche de définition de motifs 120 faite de résine puis l'ouverture de la résine par l'une des techniques classiques de photolithographie.

La figure 1d et la figure 1e montrent respectivement l'ouverture du masque dur et l'élimination de la couche de résine 120.

À ce stade, on peut réaliser une attaque du substrat 100 depuis sa face avant par gravure de sorte à définir le relief souhaité.

L'illustration donnée en figure 1f est un exemple de relief 140 en pyramide inversée qui peut être par exemple mis en oeuvre par une gravure humide ayant recours à une solution basique (par exemple à base d'hydroxyde de potassium pour un matériau de substrat à graver de type silicium). Une gravure sèche est également possible mais présente l'inconvénient d'être plus coûteuse. En fin de gravure, on peut supprimer le masque dur pour parvenir au résultat de la figure 1g.

On comprend des figures précédemment décrites qu'un grand nombre d'étapes est nécessairement impliqué par les techniques actuelles utilisant des masques durs. Ces techniques actuels induisent donc un temps de procédé et un coût qu'il serait avantageux de réduire.

Les documents WO 2016/145337 A1 et US 2015/380599 A1 décrivent des procédés comprenant une implantation d'espèces carbonées à travers un masque préalablement formé sur le substrat. L'implantation forme des motifs carbonés à la surface du substrat. Ces procédés décrivent également la gravure des zones non implantées du substrat sélectivement aux zones enrichies en carbone.

Ces procédés induisent également un temps de réalisation relativement long et un coût qu'il serait avantageux de réduire.

La présente invention a notamment pour objectif de réduire au moins en partie les inconvénients des techniques actuelles.

### RESUME DE L'INVENTION

Un aspect non limitatif de l'invention est relatif à un procédé de formation de reliefs à la surface d'un substrat.

De manière avantageuse, le procédé comprend au moins les étapes suivantes:
- une formation d'un écran de protection d'au moins une première zone de la face ;
- une implantation configurée pour introduire au moins une espèce comprenant du carbone dans le substrat depuis ladite face, la formation d'un écran et l'implantation étant configurées pour former dans le substrat au moins une couche modifiée carbonée présentant une concentration de carbone implanté supérieure ou égale à un seuil de gravure uniquement depuis une deuxième zone de ladite face non protégée par l'écran de protection;
- de préférence un retrait de l'écran de protection relativement au substrat ;
- une gravure du substrat depuis la première zone sélectivement à la deuxième zone.

A l'issue de la gravure, le procédé permet de former des reliefs.

De manière surprenante, l'invention a révélé qu'il était possible d'employer l'espèce chimique carbone comme base pour constituer une partie modifiée de la matière du substrat destiné à être gravé, de sorte à rendre résistante à la gravure cette partie modifiée. La modification par implantation de carbone appliquée au substrat évite le recours au dépôt d'un masque dur. Ainsi, il n'est pas nécessaire de former une couche de masque dur par un dépôt, ni d'effectuer les multiples étapes de lithographie nécessaires à ouvrir un tel masque pour définir les zones du substrat qui feront l'objet de la gravure. L'invention permet également de se passer de l'étape de retrait du masque dur.

Potentiellement, le nombre d'étapes mises en oeuvre par l'invention peut donc être considérablement réduit relativement aux techniques conventionnelles basées sur le dépôt d'un masque dur.

Selon l'invention, la formation de l'écran de protection comprend un dépôt d'une couche de définition de motifs sur ladite face, puis une formation, à partir de la couche de définition de motifs, d'au moins un motif sur la première zone.

En outre, la couche de définition de motifs comprend au moins une espèce carbonée et l'implantation comprend une application d'un faisceau d'ions effectuée de manière :
- à arracher depuis la couche de définition de motifs au moins un partie de l'espèce carbonée tel qu' au moins des ions carbone de l'espèce carbonée et
- à faire pénétrer un partie de l'espèce carbonée tel qu'au moins des ions carbone dans le substrat et depuis la deuxième zone.

L'implantation d'ions carbone ou d'espèces carbonées peut alors être au moins partiellement indirecte.

De manière avantageuse, cette implantation peut se faire au travers d'un dépôt de couche de définition de motifs réalisé par exemple par nanoimpression. Il n'est alors pas nécessaire de retirer l'épaisseur résiduelle dans le fond des motifs en creux, ce qui réduit le nombre total d'étapes du procédé. Les techniques de nanoimpression sont en outre généralement moins coûteuses que les techniques de lithographie nécessitant la conception de masques de lithographie.

Par ailleurs, le faisceau d'ions n'est pas nécessairement à base d'espèces carbonées. Il peut notamment être exempt d'espèces carbonées. Il peut par exemple être à base d'ions lourds, ce qui augmente la compatibilité du procédé avec des procédés existants couramment utilisés dans l'industrie de la microélectronique.
Enfin, ce mode de réalisation ne requiert pas de masque de contact ou de masque de projection, qui sont en général coûteux et peu versatiles.
De manière avantageuse, la couche de définition de motifs remplit à la fois les fonctions de masque et de source d'espèces carbonées.

### BREVE INTRODUCTION DES FIGURES

D'autres caractéristiques, buts et avantages de la présente invention apparaîtront à la lecture de la description détaillée qui suit, en regard des dessins annexés, donnés à titre d'exemples, non limitatifs, et sur lesquels :
- Les figures 1a à 1g présentent successivement des étapes mises en oeuvre selon l'état de la technique pour la réalisation de reliefs par gravure dans un substrat, avec création d'un masque dur ;
- les figures 2a à 2f illustrent en contre-point des figures 1a à 1g un mode de réalisation non limitatif de l'invention en plusieurs étapes successives ;
- les figures 3a à 3d présentent un autre mode de réalisation de l'invention avec des étapes successives ;
- la figure 4 schématise un exemple de réalisation ne faisant pas partie de la présente invention pour la définition de la couche modifiée carbonée relativement aux exemples des figures 2a à 2f et 3a à 3d ;
- la figure 5a est une vue de dessus d'un exemple de formation d'une pluralité de reliefs périodiques à la surface d'un substrat ; la figure 5b en montre une vue en coupe partielle suivant la ligne AA avec un exemple du profil des reliefs formés ;
- les figures 6a à 6e présentent des étapes successives potentielles mises en oeuvre par l'invention pour obtenir des reliefs en creux en forme de pyramide inversée ;
- la figure 7 est une vue au microscope correspondant à l'étape de la figure 6a et la figure 8 est une vue au microscope correspondant à l'exemple de la figure 6e.
- la figure 9 illustre un relief en forme d'ellipsoïde inversée obtenu selon un mode de réalisation de l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives du substrat, du masque, de la couche modifiée carbonée, des couches de résine et des motifs ne sont pas représentatives de la réalité.

### DESCRIPTION DETAILLEE

Avant d'entamer une revue détaillée de modes de réalisation de l'invention, sont énoncées ci-après des caractéristiques optionnelles qui peuvent éventuellement être utilisées suivant toute association ou alternativement :
- Selon un mode de réalisation, l'espèce comprenant du carbone est des ions de carbone et/ou au moins un composé chimique comprenant du carbone.
- Selon un mode de réalisation, le substrat est en silicium. De préférence il est pris parmi : du silicium monocristallin, du silicium multicristallin, du silicium amorphe.
- Selon un mode de réalisation, l'implantation est configurée de sorte que la couche modifiée soit d'une épaisseur supérieure ou égale à 5 nm.
- Selon un mode de réalisation, l'implantation est configurée de sorte que la couche modifiée contienne une concentration de carbone implanté d'au moins 10¹⁷ et de préférence d'au moins 10¹⁸ atomes de carbone par cm³.
- Selon un mode de réalisation, la formation de l'écran et l'implantation sont configurées pour ne produire aucune implantation dans la première zone.
- Selon un mode de réalisation, le procédé comprend un retrait de la couche modifiée après la gravure.
- Selon un mode de réalisation, le retrait comprend une gravure plasma.
- Selon un mode de réalisation alternatif, la gravure comprend au moins une étape de gravure humide. Selon un mode de réalisation, l'étape de gravure humide est configurée pour graver une région du substrat située sous la couche modifiée. Selon un mode de réalisation, la région du substrat est située sous et au contact de la totalité de la couche modifiée.
- Selon un mode de réalisation, au moins une portion de la deuxième zone forme un contour fermé autour d'au moins une portion de la première zone.
- Selon un exemple ne faisant pas partie de la présente invention, la formation d'un écran comprend le placement d'un masque au-dessus et de préférence à distance de la face, le masque étant ouvert uniquement en regard de la deuxième zone (201) selon une direction de l'implantation.
- Selon l'invention, la formation d'un écran comprend un dépôt d'une couche de définition de motifs sur la face, puis la formation, à partir de la couche de définition de motifs, d'au moins un motif sur la première zone.
- Selon un mode de réalisation, la formation d'au moins un motif comprend une élimination de toute l'épaisseur de la couche de définition de motifs dans la deuxième zone.
- Alternativement, la formation d'au moins un motif comprend une élimination d'une partie seulement de l'épaisseur de la couche de définition de motifs dans la deuxième zone, l'élimination comprenant une étape de nano impression ou une étape de lithographie.
- Selon un mode de réalisation, la couche de définition de motifs comprend au moins une sous-couche anti reflet (BARC). Cette sous-couche anti reflet peut comprendre des espèces carbonées. La couche de définition de motifs comprend de préférence également au moins une couche de résine surmontant la sous-couche anti reflet.
- Selon l'invention, la couche de définition de motifs comprend au moins une espèce carbonée et l'implantation comprend une application d'un faisceau d'ions effectuée de manière :
   ∘ à arracher depuis la couche de définition de motifs au moins des ions carbone de l'espèce carbonée et
   ∘ à faire pénétrer des ions carbone issus de l'espèce carbonée dans le substrat et depuis la deuxième zone.

On peut ainsi qualifier cette implantation « d'implantation indirecte » puisque les espèces carbonées, par exemple les ions carbone, implantées dans le substrat ne proviennent pas du faisceau mais de la couche de définition de motifs. Selon un mode de réalisation, l'implantation des espèces carbonées dans le substrat est uniquement indirecte. Cela signifie que le faisceau incident sur la couche de définition de motifs ne comprend pas d'ions carbone ou d'espèces carbonées. Selon un exemple de réalisation, la couche de définition de motifs comprend au moins une sous-couche, par exemple anti reflet, et de préférence au moins une couche supérieure, par exemple de résine, surmontant la sous-couche. La formation du motif peut consister à retirer, au droit de la deuxième zone, la couche surmontant la sous-couche.

Dans une « implantation directe », l'implantation est une implantation d'ions de carbone et/ou d'au moins un composé chimique comprenant du carbone. On peut qualifier cette implantation « d'implantation directe » puisque les espèces carbonées implantées dans le substrat proviennent du faisceau incident sur le substrat.

Selon un autre exemple de réalisation de l'invention, les deux modes de réalisation précédents sont combinés. Ainsi, les espèces carbonées implantées dans le substrat proviennent à la fois du faisceau d'ions incidents sur le substrat et à la fois de l'au moins une espèce carbonée présente de la couche de définition de motifs. Ce mode de réalisation permet de former la couche modifiée par implantation directe et indirecte (arrachement puis pénétration) de manière à renforcer la concentration de carbone implanté dans la couche modifiée.
- Selon un mode de réalisation, le faisceau d'ions est un faisceau d'ions non carbonés, et de préférence un faisceau d'ions lourds.
- Selon un mode de réalisation la formation d'au moins un motif comprend une élimination de toute l'épaisseur de la couche de définition de motifs dans la deuxième zone.

De préférence, les paramètres de l'implantation, en particulier l'inclinaison, c'est-à-dire l'angle principal d'incidence, du faisceau d'ions relativement au substrat (c'est-à-dire au plan principal dans lequel s'étend le substrat ou ladite face), sont choisis de manière à ce que les ions carbone qui pénètrent dans le substrat soient arrachés depuis des flancs du motif de la couche de définition de motifs. Typiquement, ces flancs s'étendent verticalement au plan principal dans lequel s'étend le substrat ou ladite face.

Il est précisé que, dans le cadre de la présente invention, les termes « sur », « surmonte », « recouvre », « sous-jacent » et leurs équivalents ne signifient pas forcément « au contact de ». Ainsi par exemple, le report, le collage, l'assemblage, l'application ou le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

Il est précisé que dans le cadre de la présente invention, l'épaisseur d'une couche ou du substrat se mesure selon une direction perpendiculaire à la surface selon laquelle cette couche ou ce substrat présente son extension maximale.

L'emploi du singulier pour certains éléments de l'invention ne signifie pas obligatoirement qu'un élément donné est présent de manière unique dans l'invention. Le mot « un » ou « une » ne signifie donc pas exclusivement respectivement « un seul » ou « une seule » à moins qu'il en soit disposé autrement.

Le procédé selon l'invention peut s'avérer particulièrement avantageux pour réaliser des réseaux de diffraction ou des réseaux d'absorption, par exemple pour le marché des LED ou du photovoltaïque.

La figure 2a présente, comme point de départ du procédé de l'invention, un substrat 100 qui peut être équivalent au substrat conventionnel relaté dans la section d'arrière-plan technologique de la présente description. L'invention va permettre de réaliser des reliefs à partir d'une face 101 de ce substrat.

Le substrat 100 peut être autoportant ou non. Il peut reposer ou non sur une ou plusieurs autre(s) couche(s). Le substrat 100 peut être monocristallin, polycristallin ou amorphe selon les applications considérées. Le substrat est typiquement fait d'un matériau comprenant au moins l'un des matériaux suivants : silicium (Si), silicium-germanium (SiGe) saphir, SiN et quartz. Par exemple le substrat 100 peut être en silicium (Si), en silicium-germanium (SiGe) de préférence monocristallin ou polycristallin. Le substrat 100 peut également être en quartz ou en saphir.

La figure 2b est une vue de détail de la figure 2a et montre par ailleurs qu'une couche 210 a été formée sur la face 101. Cette couche 210 est avantageusement faite de résine et sera utilisée pour définir des motifs permettant de discriminer une première zone du substrat relativement à une deuxième zone. Dans le cadre de la présente invention, on qualifie de résine un matériau organique ou organo-minéral pouvant être mis en forme par une exposition à un faisceau d'électrons, de photons ou de rayons X ou mécaniquement.

Les représentations des figures 2b à 2f se concentrent sur un détail B de la figure 2a et donc sur une région limitée du substrat 100. Bien entendu, l'exemple fourni dans ces représentations peut être étendu sur une plus grande partie du substrat 100, notamment pour former une pluralité de motifs de protection 220 décrits ci-après et une pluralité de reliefs.

La figure 2c montre justement une mise en forme de la couche 210 de manière mécanique par exemple par nano impression. On a par ce biais défini un motif de protection 220 qui présente avantageusement la même épaisseur que l'épaisseur initiale de la couche 210. Le motif de protection 220 recouvre une première zone, repérée à la référence 240 à la figure 2e, de la face 101 du substrat 100.

Une deuxième zone 221 de la face 101 du substrat 100 est recouverte d'une épaisseur réduite par rapport à l'épaisseur de la couche 210 d'origine, comme illustré par le mode de réalisation de la figure 2d. C'est notamment le cas lorsque le motif de protection 220 est formé par nanoimpression, ce type de technique laissant en place une épaisseur résiduelle dans le fond des motifs en creux.

Le cas d'une partie résiduelle de la couche 210 au niveau de la deuxième zone 221 peut aussi se produire par l'utilisation d'une couche 210 comprenant, outre une première sous-couche de résine proprement dite, une sous-couche sous-jacente à la première ayant une fonctionnalité de lutte contre la réflexion optique lors de la phase d'insolation de la résine. Ces matériaux peuvent être du type connu sous l'acronyme BARC (pour désigner en anglais : bottom anti-reflective coating, signifiant sous-couche anti reflet). Dans ce cas, il est possible de laisser subsister la sous-couche anti reflet dans la deuxième zone 221.

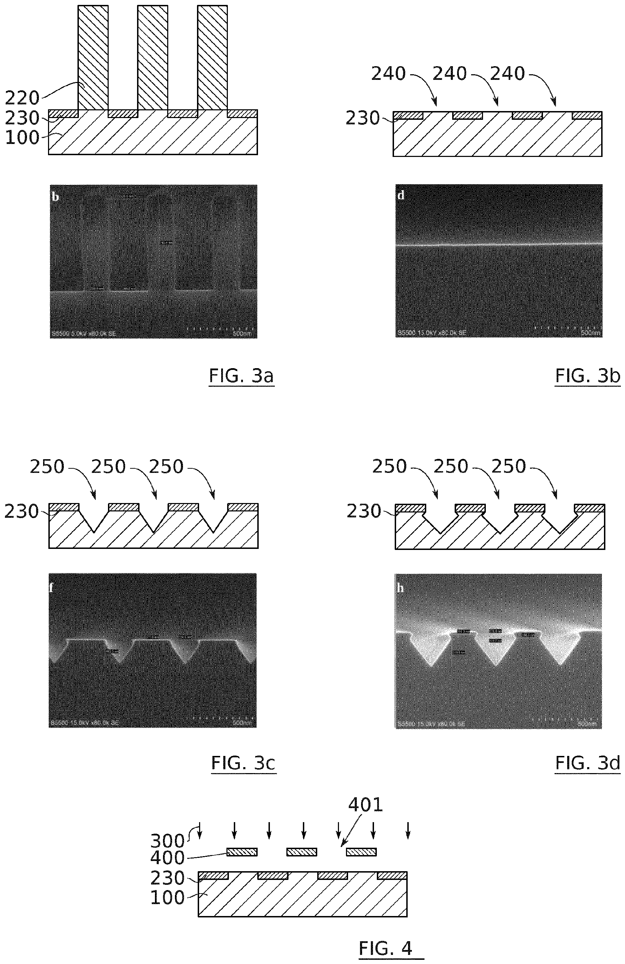

Selon un mode de réalisation (illustré en figure 3a qui sera décrite en détail par la suite), l'épaisseur de la couche 210 d'origine est nulle au droit la deuxième zone 221. Dans ce cas, le matériau de la couche 210 est totalement éliminé dans la deuxième zone 221.

À ce stade, on a ainsi réalisé un écran de degré de protection plus élevé au niveau de la première zone 240 que de la deuxième zone 221, par la présence du motif de protection 220. Les termes « première zone » et « deuxième zone » s'entendent ici de deux portions distinctes du substrat 100 accessibles depuis la face 101. La configuration de ces zones n'est pas limitée par l'invention. Par exemple, la deuxième zone 221 peut être organisée en quadrillage comme le montreront des exemples ultérieurs et la première zone 240 peut être organisée en une pluralité de portions discontinues du substrat 100.

Une phase d'implantation 300 présentée à la figure 2d est ensuite opérée depuis la face 101. Cette implantation impacte le substrat de manière différente selon qu'elle est dirigée vers la première zone 240 recouverte d'un motif de protection 220 ou vers la deuxième zone 221 qui n'est plus recouverte de résine ou faiblement recouverte. La formation des motifs 220 assure donc une sélectivité d'implantation. L'objectif de l'implantation est de modifier le matériau du substrat 100 à partir de la face 101 de sorte à produire une couche modifiée 230 carbonée dont les propriétés sont suffisamment différentes de celles du matériau du substrat 100 pour réaliser ensuite une gravure sélective de ce dernier matériau relativement au matériau de la couche modifiée.

Avantageusement, l'épaisseur de la couche modifiée 230 depuis la face 101 est supérieure ou égale à 5 nm et avantageusement supérieure ou égale à 20 nm. La concentration d'implantation correspondant à la densité d'atomes de carbone par unité de volume dans la couche modifiée 230 est de préférence supérieure ou égale à 10¹⁸ atomes par cm³.

L'implantation est en partie au moins indirecte. On entend par là que l'implantation s'opère avec un faisceau d'ions non carbonés, par exemple avec des ions lourds, comme l'argon, de sorte à arracher à la couche de définition de motifs 210 des espèces carbonées, typiquement des atomes de carbones. Une partie au moins de ces espèces carbonées extraits de la couche de définition de motifs 210, pénètrent ensuite, dans la deuxième zone 221 du substrat 100. Dans cette deuxième zone 221, le matériau du substrat est alors enrichi en carbone. Cette contamination du substrat peut être obtenue avec ou sans épaisseur résiduelle de couche de définition de motifs 210 au niveau de la deuxième zone 221. Selon un mode de réalisation, le faisceau incident sur la couche 210 est exempt d'espèces carbonées. Une implantation uniquement indirecte permet d'éviter les inconvénients liés à l'utilisation du carbone, en particulier sur les équipements utilisés lors d'implantation.

Naturellement, si cette épaisseur résiduelle est présente il faut que son épaisseur soit suffisamment faible pour permettre aux ions lourds implantés de déplacer les atomes de carbone jusque dans le substrat 100. En tout état de cause, si la couche de définition de motifs 210 comprend des espèces carbonées, ce qui est le cas s'il s'agit d'une couche de résine, alors ces espèces carbonées peuvent être déplacées jusque dans le substrat 100 par les ions lourds implantés. On qualifie de « lourds » des ions dont la masse est supérieure ou égale à celle de l'oxygène (O2) et préférence supérieure ou égale à celle de l'argon (Ar)

Si la deuxième zone 221 du substrat 100 n'est pas recouverte par une épaisseur résiduelle de couche de définition de motifs 210, les atomes de carbone sont arrachés sur les flancs et les sommets des motifs 220.

Dans le cas d'utilisation d'une technique de formation de motifs mettant en oeuvre une sous-couche antireflet comme précédemment décrite (par exemple BARC), cette sous-couche peut persister au niveau de la deuxième zone 221 et la contamination en carbone peut être produite à partir des espèces carbonées de cette matière. Ainsi, dans ce cas, la couche 210 de formation des motifs comprend un empilement de couches, l'empilement comprenant au moins une sous-couche par exemple de type couche d'arrêt et/ou de type BARC surmontée d'au moins une couche supérieure, par exemple en résine. La formation des motifs peut consister à supprimer la couche supérieure et à conserver la sous-couche. L'implantation se fait alors à travers la sous-couche.

Suivant un premier mode de réalisation, l'implantation est réalisée uniquement de manière indirecte.

Suivant d'autres modes de réalisation, l'implantation combine une implantation indirecte et une implantation directe.

Selon une première variante, l'implantation directe est réalisée par des faisceaux d'ions carbone. Par exemple, on peut avoir recours à un implanteur d'ions pour implanter des ions carbone à 5 kev et une dose par unité de surface de 10¹⁶ atomes de carbone par cm². Pour un substrat en silicium, cela permet de produire une épaisseur de couche modifiée de 30 nm s'il n'y a plus de couche 210 surmontant la deuxième zone 221. Selon cette possibilité, le faisceau d'ion incident sur la couche 210 portant les motifs 220 comprend des ions carbone uniquement ou des ions carbone et d'autres espèces.

Suivant une autre possibilité, l'implantation directe s'opère par projection de faisceaux d'ions plus complexes mais comprenant au moins une espèce comprenant du carbone. Cette dernière technique peut être mise en oeuvre par immersion plasma ou dans un réacteur de gravure auquel cas les éléments du gaz carboné du plasma qui est utilisé seront implantés. On pourra utiliser cette dernière technique pour réaliser une implantation sur une plus petite profondeur dans le substrat 100.

Ainsi, il est possible de combiner les deux modes de réalisation précédemment décrits, c'est-à-dire implantation indirecte et implantation directe. Ainsi, le carbone implanté dans le substrat peut provenir simultanément d'une implantation directe et d'une implantation indirecte. Typiquement, la couche 210 recouvre la deuxième zone et contient des espèces carbonées. Le faisceau d'ions parvenant sur la couche 210 contient du carbone et éventuellement d'autres espèces tels que des ions lourds. Ce faisceau traverse en partie au moins la couche 210 au droit de la deuxième zone pour amener les ions carbone qu'il contient jusque dans le substrat 100 (implantation directe). Par ailleurs, le faisceau arrache des espèces carbonées, par exemple des ions carbone, dans la couche 210 carbonée et fait pénétrer ces espèces jusque dans le substrat 100 (implantation indirecte).

Ce mode de réalisation permet d'enrichir encore plus facilement en carbone la couche modifiée 230.

L'implantation 300 est de préférence dirigée suivant la dimension en épaisseur du substrat 100.

Les conditions d'implantation sont réglées pour que seule la deuxième zone 221 recevant une dose d'ions carbone dépasse un seuil au-delà duquel le matériau du substrat est suffisamment modifié pour devenir nettement moins sensible à une gravure que le matériau non modifié ou modifié avec une dose inférieure au seuil. Ainsi, suivant une première possibilité, le matériau du substrat 100 n'est absolument pas modifié (aucune implantation de carbone réalisée) dans la première zone 240. Suivant une deuxième possibilité, le matériau du substrat 100 peut y subir une implantation de sorte à former une couche présentant une modification, mais cette modification est configurée pour ne pas dépasser le seuil prédéfini. Par exemple cette modification dans la première zone 240 reste inférieure d'au moins 20 % et de préférence d'au moins 50 % à ce seuil.

Après l'étape d'implantation, la partie résiduelle de la couche de définition de motifs 210, c'est-à-dire pour le moins les motifs 220, est supprimée, par exemple par une technique classique de lift-off. À ce stade, le substrat comporte des portions dotées de la couche modifiée 230 et des portions pour lesquelles le matériau d'origine du substrat 100 reste exposé au niveau de la face 101, comme le révèle la figure 2e.

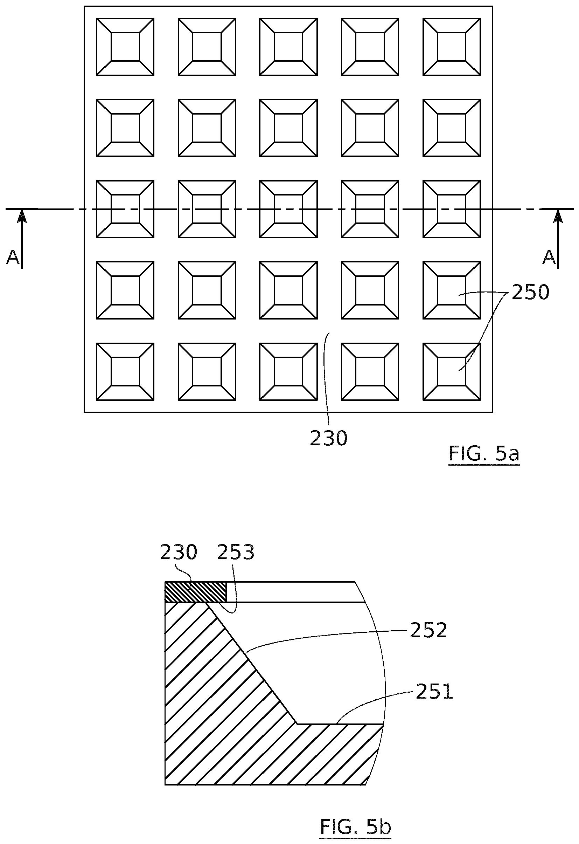

Une gravure est alors opérée de sorte à produire les reliefs désirés en creux depuis la face 101 vers l'intérieur du substrat 100 au niveau de la première zone 240. Cette gravure peut être effectuée par voie humide, par exemple avec des solutions basiques telles que telles que l'hydroxyde de potassium (KOH), de l'hydroxyde de sodium (NaOH) ou le tetramethylammonium hydroxide (TMAH) ; l'ajout de surfactant et/ou d'alcool est également possible. La gravure humide peut être réalisée à chaud ou à froid selon la vitesse de gravure voulue. L'anisotropie de la gravure humide basique peut permettre de graver une région du substrat 100 située en dessous de la couche modifiée 230 comme visible en figure 2f et plus précisément en figure 5b au niveau du repère 253.

Suivant un autre mode de réalisation, on opère une gravure sèche, typiquement suivant la technique de gravure ionique réactive connue sous l'acronyme RIE.

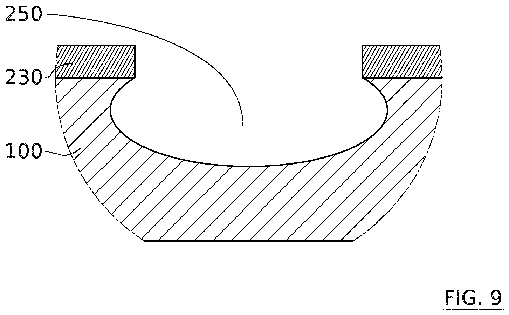

Il est possible également de réaliser une gravure humide isotrope, par exemple à l'aide d'une solution acide notamment à base de HF du type Hf + HNO3 ou Hf + H2O2. On obtient dans ce cas, non plus des pyramides inversés, mais des structures en forme de « boule », de sphère ou d'ellipsoïde inversée. Cette « boule » s'étend latéralement sous la couche carbonée si on augmente le temps de gravure. La figure 9 illustre ce type de structure.

On notera que pour de nombreuses applications on peut conserver la couche modifiée 230 en fin de procédé. Tel est le cas pour les applications où l'on cherche essentiellement à obtenir des propriétés géométriques ou mécaniques du substrat, comme c'est le cas pour les cellules photovoltaïques.

Selon un autre mode de réalisation, on peut retirer la couche modifiée 230. Il est alors possible d'éliminer la couche carbonée 230 sélectivement aux portions non modifiées du substrat 100.

Pour cela, on peut retirer cette couche carbonée en utilisant un plasma oxydant à base de dioxygène ou un mélange O₂/N₂, O₂/Ar ou un plasma réducteur à base de H₂, H₂/N₂ ou H₂/Ar, dans l'exemple d'un substrat 100 de silicium dont la couche 230 est du silicium carboné. Suivant un autre exemple, si la couche est du type silicium incorporant du graphite, on peut utiliser un plasma à base de CF₄ pour la retirer.

Selon encore un autre mode de réalisation qui dépend de la géométrie de la couche modifiée 230 et de la gravure du substrat 100, il est possible d'éliminer la couche modifiée 230 automatiquement sans avoir recours à une étape additionnelle. Tel est le cas lorsque la gravure est anisotrope et retire une partie du substrat 100 située sous la couche modifiée 230 jusqu'à rencontrer la gravure formée au niveau d'un relief en creux adjacent. La couche modifiée 230 située entre ces deux reliefs adjacents n'est alors plus soutenue et est automatiquement retirée. Ce cas de figure est décrit plus en détail en référence aux figures 3d et 5b

Les figures 3a à 3d présentent de façon plus globale un mode de réalisation de l'invention pour former une pluralité de reliefs suivant un motif déterminé à la surface du substrat 100.

Ainsi, la figure 3a est une représentation d'une pluralité de motifs de protection 220 autour desquels des portions de couche modifiée 230 ont été produites par une implantation avec des espèces carbonées. Dans cet exemple, il n'y a pas de résine résiduelle au niveau des portions non couvertes par les motifs 220, comme cela peut être typiquement le cas par l'utilisation d'une technique de lithographie pour réaliser la mise en forme de la résine dont les motifs 220 sont issus. Le retrait des motifs 220 produit le résultat présenté à la figure 3b.

Comme précédemment, une gravure est opérée à la figure 3c, générant des flancs inclinés au niveau d'une pluralité de zones gravées 250 chacune correspondant à une portion de la première zone 240 non protégée par la couche modifiée 230. La poursuite de la gravure produit une région gravée sous-jacente à la couche modifiée 230, formant ainsi une gravure rentrante 253 (voir figure 3d) présentée plus en détail dans le mode de réalisation de la figure 5b. Bien que non représenté, il est possible de poursuivre la gravure de sorte qu'elle s'étende latéralement (c'est-à-dire perpendiculairement à la dimension en épaisseur du substrat 100) pour réduire encore la zone de la couche modifiée 230 au contact du matériau sous-jacent du substrat 100. Il est possible de poursuivre la gravure jusqu'à ce que cette réduction détruise totalement le fondement de la couche modifiée 230 qui ne se trouve alors plus soutenue par le substrat 100 proprement dit. Cette configuration peut permettre de retirer la couche modifiée 230 au cours de la gravure, sans étape spécifique, comme indiqué ci-dessus.

La figure 4 fournit un exemple de réalisation ne faisant pas partie de la présente invention dans lequel l'écran de protection, permettant de limiter l'implantation carbonée au-delà du seuil prédéfini dans la deuxième zone 221, est réalisé avec un masque 400 disposé au-dessus de la face 101 du substrat 100 et comportant une ou plusieurs ouvertures 401 correspondant à la définition de la deuxième zone 221. Ce masque 400 peut être placé à distance de la face 101, c'est-à-dire à distance de l'empilement comprenant le substrat 100. De préférence ce masque 400 est réutilisable d'un substrat 100 à un autre.

Typiquement le masque 400 formant écran de protection est compris dans un équipement d'implantation par lequel l'implantation 300 d'espèces carbonées est effectuée. Le substrat 100 est introduit dans l'équipement en étant placé en regard du masque 400 formant écran de protection. En fin d'implantation 300 et avant l'étape de gravure du substrat 100, ce dernier est déplacé hors de l'équipement d'implantation, cette étape correspond ainsi à un retrait du masque 400 formant écran de protection relativement au substrat 100.

On comprend que l'implantation 300 n'impacte que les zones souhaitées du substrat 100. Dans cette configuration, l'implantation 300 comprendra des ions carbone et/ou des ions de composés carbonés. Les paramètres d'implantation peuvent être du type présentés pour les modes de réalisation précédents. Le masque 400 est par exemple en aluminium.

L'invention ne comprend pas de mode de réalisation dans lesquels l'implantation de carbone est effectuée uniquement de manière directe.

En termes d'applications, l'invention permet par exemple de fabriquer des reliefs sous forme de pyramide inversée tronquée à destination par exemple de la fabrication de MEMS. C'est cet exemple qui est révélé par la figure 5a en vue de dessus d'une plaque, notamment de silicium, constitutif d'un substrat 100. Les zones gravées 250 sont issues d'une gravure après délimitation des motifs à graver par une couche modifiée 230. Dans l'exemple, cette couche modifiée forme un quadrillage permettant de former un contour continu autour de chaque zone gravée 250 mais ce n'est pas nécessairement le cas pour la réalisation de MEMS.

Le profil des zones gravées 250 est visible en coupe partielle à la figure 5b au niveau de laquelle on note que la pyramide est tronquée, à savoir qu'elle comporte un fond 251, de préférence de section carrée, et une paroi latérale 252 formant une pente allant en s'évasant depuis le fond 251 en direction de la face 101 du substrat 100. Comme précédemment indiqué, la cinétique de la gravure, humide, peut être configurée pour attaquer une zone 253 sous-jacente à la couche modifiée 230.

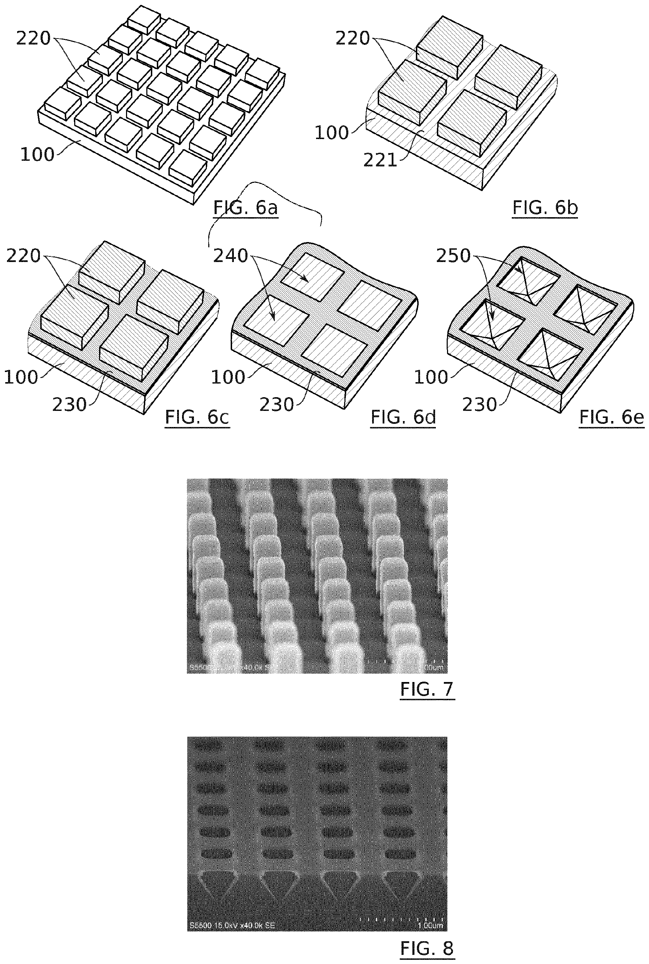

Un exemple supplémentaire de formation de ce type de motifs est fourni en référence aux figures 6a à 6e, avec des reliefs cette fois en forme de pyramide inversée non tronquée qui peuvent notamment être destinée à la fabrication de cellules photovoltaïques. Ainsi dans ce nouvel exemple le temps de gravure est supérieur à celui du mode de réalisation précédent. En figure 6a, les motifs de protection 220 ont été formés, par exemple par lithographie sur la base d'une couche de résine 210 comme précédemment. En figure 6b, on note plus en détail que les motifs 220 sont séparés les uns des autres par une deuxième zone 221 de la face 101 du substrat 100. C'est cette zone qui subit la modification formant la couche modifiée 230 par l'implantation précédemment décrite (figure 6c). S'ensuit un retrait de la matière des motifs 220 de sorte à exposer la première partie 240 au niveau de la face 101 du substrat 100, cette portion n'étant pas protégée de la gravure au contraire de la couche modifiée 230 (figure 6d). Enfin, comme illustré en figure 6e la gravure est produite comme précédemment, avantageusement par voie humide, de sorte à générer des motifs en pente ayant la forme d'une pyramide inversée.

La figure 7 révèle une représentation photographique issue d'une observation au microscope d'une situation sensiblement correspondante à celle de la figure 6a. La figure 8 correspond quant à elle une représentation photographique issue d'une observation microscopique du résultat final, de manière similaire à la figure 6e.

Sauf indication spécifique du contraire, des caractéristiques techniques décrites en détail pour un mode de réalisation donné peuvent être combinées à des caractéristiques techniques décrites dans le contexte d'autres modes de réalisation décrits à titre exemplaire et non limitatif, dont ceux expliqués en détail ci-dessus.

Au vu de la description qui précède, il apparaît clairement que l'invention propose une solution reproductible et présentant un nombre d'étapes réduit pour obtenir des reliefs dans un substrat.

L'invention n'est pas limitée aux modes de réalisations précédemment décrits et s'étend à tous les modes de réalisation couverts par les revendications.

### REFERENCES

- 100.: Substrat
- 101.: Face
- 110.: Couche de masque dur
- 120.: Couche de définition de motif
- 130.: Motif
- 140.: Relief gravée
- 210.: Couche de définition de motif
- 220.: Motif de protection
- 221.: Zone
- 230.: Couche modifiée
- 240.: Première zone
- 250.: Zone gravée
- 251.: Fond
- 252.: Paroi latérale
- 253.: Gravure rentrante
- 300.: Implantation
- 400.: Masque
- 401.: Ouverture

## Revendications

1. Procédé de formation de reliefs sur une face (101) d'un substrat (100) comprenant successivement au moins les étapes suivantes :
- une formation d'un écran de protection d'au moins une première zone (240) de la face (101) ;
- une implantation configurée pour introduire au moins une espèce comprenant du carbone dans le substrat (100) depuis ladite face (101), la formation d'un écran et l'implantation étant configurées pour former dans le substrat (100) au moins une couche modifiée (230) carbonée présentant une concentration de carbone implanté supérieure ou égale à un seuil de gravure uniquement depuis une deuxième zone (221) de ladite face (101) non protégée par l'écran de protection, de sorte que la couche modifiée (230) carbonée est plus résistante à la gravure que le matériau du substrat situé dans la première zone (240),
- un retrait de l'écran de protection ;
- une gravure de la première zone (240) du substrat (100) sélectivement à la deuxième zone (221),
ledit procédé étant caractérisé en ce :
la formation d'un écran comprend un dépôt d'une couche de définition de motifs (210) sur ladite face (101) du substrat (100), puis une formation, à partir de la couche de définition de motifs (210), d'au moins un motif (220) sur la première zone (240), la couche de définition de motifs (210) comprenant au moins une espèce carbonée, et en ce que :
l'implantation comprend une application d'un faisceau d'ions effectuée de manière :
- à arracher de la couche de définition de motifs (210) au moins des ions carbone de l'espèce carbonée et
- à faire pénétrer des ions carbone, arrachés de la couche de définition de motifs (210), dans la deuxième zone (221) du substrat (100).

2. Procédé selon la revendication précédente, dans lequel l'implantation est configurée de sorte que la couche modifiée (230) soit d'une épaisseur supérieure ou égale à 5 nm.

3. Procédé selon l'une des revendications précédentes, dans lequel l'implantation est configurée de sorte que la couche modifiée (230) contienne une concentration de carbone implanté d'au moins 10¹⁷ et de préférence d'au moins 10¹⁸ atomes de carbone par cm³.

4. Procédé selon l'une des revendications précédentes, dans lequel la formation de l'écran et l'implantation sont configurées pour ne produire aucune implantation dans la première zone (240).

5. Procédé selon l'une des revendications précédentes, comprenant un retrait de la couche modifiée (230) après la gravure.

6. Procédé selon la revendication précédente, dans lequel le retrait comprend une gravure plasma.

7. Procédé selon l'une des revendications précédentes, dans lequel la gravure comprend au moins une étape de gravure humide.

8. Procédé selon la revendication précédente, dans lequel l'étape de gravure humide est configurée pour graver une région du substrat (100) située sous la couche modifiée (230).

9. Procédé selon la revendication précédente, dans lequel la région du substrat (100) est située sous et au contact de la totalité de la couche modifiée (230).

10. Procédé selon l'une des revendications précédentes, dans lequel au moins une portion de la deuxième zone (221) forme un contour fermé autour d'au moins une portion de la première zone (240).

11. Procédé selon l'une des revendications précédentes, dans lequel la formation d'au moins un motif (220) comprend une élimination de toute l'épaisseur de la couche de définition de motifs (210) dans la deuxième zone (221), et dans lequel, de préférence, les paramètres de l'implantation, en particulier l'inclinaison du faisceau d'ions relativement au substrat (100), sont choisis de manière à ce que les ions carbone qui pénètrent dans le substrat (100) soient arrachés depuis des flancs du motif (220) de la couche de définition de motifs (210).

12. Procédé selon l'une des revendications 1 à 10, dans lequel la formation d'au moins un motif (220) comprend une élimination d'une partie seulement de l'épaisseur de la couche de définition de motifs (210) dans la deuxième zone (221), l'élimination comprenant une étape de nano impression ou une étape de lithographie.

13. Procédé selon la revendication précédente, dans lequel la couche de définition de motifs (220) comprend au moins une sous-couche, par exemple anti reflet, et de préférence au moins une couche de résine surmontant la sous-couche.

14. Procédé selon l'une des revendications précédentes dans lequel le faisceau d'ions est un faisceau d'ions non carbonés, et de préférence un faisceau d'ions lourds.

15. Procédé selon l'une des revendications précédentes, dans lequel le substrat (100) est formé de ou est à base de l'un parmi : du silicium monocristallin, du silicium multicristallin, du silicium amorphe.

## Patentansprüche

1. Verfahren zur Bildung von Reliefs auf einer Seite (101) eines Substrats (100), umfassend nacheinander mindestens die folgenden Schritte:
- ein Bilden einer Abschirmung zum Schutz mindestens einer ersten Zone (240) der Seite (101);
- eine Implantation, die dazu ausgestaltet ist, mindestens eine Kohlenstoff umfassende Spezies in das Substrat (100) von der Seite (101) aus einzubringen, wobei das Bilden einer Abschirmung und die Implantation dazu ausgestaltet sind, im Substrat (100) mindestens eine kohlenstoffhaltige modifizierte Schicht (230) zu bilden, die eine Konzentration an implantiertem Kohlenstoff größer oder gleich einer Ätzschwelle nur von einer zweiten Zone (221) der Seite (101) aus, die nicht durch die Schutzabschirmung geschützt ist, aufweist, so dass die kohlenstoffhaltige modifizierte Schicht (230) ätzbeständiger ist als das in der ersten Zone (240) gelegene Material des Substrats,
- einen Entfernen der Schutzabschirmung;
- ein Ätzen der ersten Zone (240) des Substrats (100) selektiv zur zweiten Zone (221),
wobei das Verfahren **dadurch gekennzeichnet ist, dass**:
- das Bilden einer Abschirmung ein Aufbringen einer Musterdefinitionsschicht (210) auf die Seite (101) des Substrats (100), dann ein Bilden, ausgehend von der Musterdefinitionsschicht (210), mindestens eines Musters (220) auf der ersten Zone (240) umfasst, wobei die Musterdefinitionsschicht (210) mindestens eine kohlenstoffhaltige Spezies umfasst, und dadurch, dass:
- die Implantation ein Applizieren eines lonenstrahls umfasst, das so ausgeführt wird, dass:
- der Musterdefinitionsschicht (210) mindestens Kohlenstoffionen der kohlenstoffhaltigen Spezies entrissen werden und
- man die der Musterdefinitionsschicht (210) entrissenen Kohlenstoffionen in die zweite Zone (221) des Substrats (100) eindringen lässt.

2. Verfahren nach dem vorhergehenden Anspruch, bei dem die Implantation so ausgestaltet ist, dass die modifizierte Schicht (230) eine Dicke größer oder gleich 5 nm hat.

3. Verfahren nach einem der vorhergehenden Ansprüche, bei dem die Implantation so angelegt ist, dass die modifizierte Schicht (230) eine Konzentration an implantiertem Kohlenstoff von mindestens 10¹⁷ und bevorzugt mindestens 10¹⁸ Kohlenstoffatomen je cm³ enthält.

4. Verfahren nach einem der vorhergehenden Ansprüche, bei dem das Bilden der Abschirmung und die Implantation so ausgestaltet sind, dass in der ersten Zone (240) keine Implantation erzeugt wird.

5. Verfahren nach einem der vorhergehenden Ansprüche, umfassend ein Entfernen der modifizierten Schicht (230) nach dem Ätzen.

6. Verfahren nach dem vorhergehenden Anspruch, bei dem das Entfernen ein Plasmaätzen umfasst.

7. Verfahren nach einem der vorhergehenden Ansprüche, bei dem das Ätzen mindestens einen Nassätzschritt umfasst.

8. Verfahren nach dem vorhergehenden Anspruch, bei dem der Nassätzschritt so ausgestaltet ist, dass eine Region des Substrats (100) geätzt wird, die unter der modifizierten Schicht (230) gelegen ist.

9. Verfahren nach dem vorhergehenden Anspruch, bei dem die Region des Substrats (100) unter und in Kontakt mit der gesamten modifizierten Schicht (230) gelegen ist.

10. Verfahren nach einem der vorhergehenden Ansprüche, bei dem mindestens ein Abschnitt der zweiten Zone (221) eine geschlossene Kontur um mindestens einen Abschnitt der ersten Zone (240) bildet.

11. Verfahren nach einem der vorhergehenden Ansprüche, bei dem das Bilden mindestens eines Musters (220) eine Eliminierung der gesamten Dicke der Musterdefinitionsschicht (210) in der zweiten Zone (221) umfasst und bei dem bevorzugt die Parameter der Implantation, insbesondere die Neigung des lonenstrahls in Bezug auf das Substrat (100), so gewählt sind, dass die Kohlenstoffionen, die in das Substrat (100) eindringen, von den Flanken des Musters (220) der Musterdefinitionsschicht (210) aus entrissen werden.

12. Verfahren nach einem der Ansprüche 1 bis 10, bei dem das Bilden mindestens eines Musters (220) eine Eliminierung nur eines Teils der Dicke der Musterdefinitionsschicht (210) in der zweiten Zone (221) umfasst, wobei die Eliminierung einen Nano-Imprint-Schritt oder einen Lithografieschritt umfasst.

13. Verfahren nach dem vorhergehenden Anspruch, bei dem die Musterdefinitionsschicht (220) mindestens eine Teilschicht, beispielsweise reflexfrei, und bevorzugt mindestens eine Harzschicht, die über der Teilschicht liegt, umfasst.

14. Verfahren nach einem der vorhergehenden Ansprüche, bei dem der lonenstrahl ein Strahl nicht kohlenstoffhaltiger Ionen ist und bevorzugt ein Schwerionenstrahl ist.

15. Verfahren nach einem der vorhergehenden Ansprüche, bei dem das Substrat (100) aus einem der folgenden gebildet wird oder darauf basiert: monokristallines Silicium, multikristallines Silicium, amorphes Silicium.

## Claims

1. Method for forming reliefs on a face (101) of a substrate (100) comprising successively at least the following steps:
- formation of a screen for protecting at least a first region (240) of the face (101);
- an implantation configured to introduce at least one species comprising carbon in the substrate (100) from said face (101), the formation of a screen and the implantation being configured so as to form in the substrate (100) at least one carbonaceous modified layer (230) having a concentration of implanted carbon greater than or equal to an etching threshold solely from a second region (221) of said face (101) not protected by the protective screen, so that the carbonaceous modified layer (230) is more resistant to etching than the material of the substrate situated in the first region (240),
- removal of the protective screen;
- etching of the first region (240) of the substrate (100) selectively with respect to the second region (221),
said method being **characterised in that**:
the formation of a screen comprises a deposition of a pattern definition layer (210) on said face (101) of the substrate (100), and then a formation, from the pattern definition layer (210), of at least one pattern (220) on the first region (240), the pattern definition layer (210) comprising at least one carbonaceous species, and **in that**:
the implantation comprises an application of an ion beam effected so as:
- to extract from the pattern definition layer (210) at least carbon ions of the carbonaceous species, and
- to make carbon ions extracted from the pattern definition layer (210) penetrate the second region (221) of the substrate (100).

2. Method according to the preceding claim, wherein the implantation is configured so that the modified layer (230) has a thickness greater than or equal to 5 nm.

3. Method according to either of the preceding claims, wherein the implantation is configured so that the modified layer (230) contains a concentration of implanted carbon of at least 10¹⁷ and preferably at least 10¹⁸ atoms of carbon per cm³.

4. Method according to any of the preceding claims, wherein the formation of the screen and the implantation are configured so as to produce no implantation in the first region (240).

5. Method according to any of the preceding claims, comprising a removal of the modified layer (230) after etching.

6. Method according to the preceding claim, wherein the removal comprises plasma etching.

7. Method according to any of the preceding claims, wherein the etching comprises at least one wet etching step.

8. Method according to the preceding claim, wherein the wet etching step is configured to etch a region of the substrate (100) situated under the modified layer (230).

9. Method according to the preceding claim, wherein the region of the substrate (100) is situated under and in contact with the whole of the modified layer (230).

10. Method according to any of the preceding claims, wherein at least a portion of the second region (221) forms a closed contour around at least one portion of the first region (240).

11. Method according to any of the preceding claims, wherein the formation of at least one pattern (220) comprises an elimination of the entire thickness of the pattern definition layer (210) in the second region (221), and wherein, preferably, the parameters of the implantation, in particular the inclination of the ion beam relative to the substrate (100), are chosen so that the carbon ions that penetrate the substrate (100) are detached from flanks of the pattern (220) of the pattern definition layer (210).

12. Method according to any of claims 1 to 10, wherein the formation of at least one pattern (220) comprises an elimination of only part of the thickness of the pattern definition layer (210) in the second region (221), the elimination comprising a nanoprinting step or a lithography step.

13. Method according to the preceding claim, wherein the pattern definition layer (220) comprises at least one underlayer, for example non-reflecting, and preferably at least one resin layer on top of the underlayer.

14. Method according to any of the preceding claims, wherein the beam of ions is a beam of non-carbonaceous ions, and preferably a beam of heavy ions.

15. Method according to any of the preceding claims, wherein the substrate (100) is formed from or is based on one from among: monocrystalline silicon, multicrystalline silicon, amorphous silicon.
